# EUROPÄISCHE PATENTSCHRIFT

(11) **EP 2 915 256 B1**
(45) Veröffentlichungstag und Bekanntmachung des Hinweises auf die Patenterteilung: **20.01.2021**
(21) Anmeldenummer: 13779862.5
(22) Anmeldetag: 22.10.2013
(51) Int. Cl.: H03K 17/96

(54) **EINGABEEINRICHTUNG UND VERFAHREN ZUM GENERIEREN EINES STEUERSIGNALS**
INPUT DEVICE AND METHOD FOR GENERATING A CONTROL SIGNAL
DISPOSITIF DE SAISIE ET PROCÉDÉ DE GÉNÉRATION D'UN SIGNAL DE COMMANDE

(30) Priorität: 31.10.2012 EP 12190817
(43) Veröffentlichungstag der Anmeldung: 09.09.2015
(73) Patentinhaber: Inventio AG, 6052 Hergiswil (CH)
(72) Erfinder: BÜNTER, Adrian, CH-6074 Giswil (CH)
(86) Internationale Anmeldenummer: PCT/EP2013/072081
(87) Internationale Veröffentlichungsnummer: WO 2014/067817

(56) Entgegenhaltungen:
- EP-A1- 0 164 662
- WO-A1-2009/153386
- WO-A1-2012/058777
- DE-A1- 10 103 563
- DE-B3-102009 011 558
- US-A- 4 805 739
- US-A- 5 587 567
- US-A1- 2007 089 939
- US-A1- 2009 312 051

## Beschreibung

Die Erfindung betrifft eine Eingabeeinrichtung und ein Verfahren zum Generieren eines Steuersignals durch Ausüben einer Druckkraft auf eine Eingabezone eines plattenförmigen Elements.

Aus WO 2009/153386 A1 ist eine Ruf-Eingabeeinrichtung einer Aufzugsanlage bekannt, die ein Steuerpaneel zur Generierung von elektrischen Steuersignalen zur Beeinflussung der Aufzugssteuerung umfasst. Beim Steuerpaneel handelt es sich um eine ebene und durchbrechungsfreie Platte mit mehreren berührungssensitiven Zonen, von denen jede einem von mehreren zu generierenden unterschiedlichen Steuersignalen zugeordnet ist. Am Steuerpaneel ist mindestens ein Sensor angebracht, der die durch Berührung einer der berührungssensitiven Zonen generierten Schwingungen des Steuerpaneels beim Sensor erfasst und an eine Rechnereinheit übermittelt. Die Rechnereinheit vergleicht die erfassten Schwingungsdaten mit gespeicherten Schwingungsdaten, die bei einem Kalibrierungsvorgang durch Berührung jeder einzelnen berührungssensitiven Zone generiert und gespeichert wurden. Bei Übereinstimmung der aktuell erfassten Schwingungsdaten mit den gespeicherten, einer bestimmten berührungssensitiven Zone zugeordneten Schwingungsdaten, generiert die Ruf-Eingabeeinrichtung ein Steuersignal, das die Steuerung der Aufzugsanlage informiert, dass die bestimmte berührungssensitive Zone aktiviert ist.

US 5587567 A beschreibt eine Eingabevorrichtung, die eine flache Platte aufweist und diese als ein Element einer Aufzugsanlage verwenden kann. Dabei befindet sich eine Folie als ein piezoelektrischer Sensor zwischen der flachen Platte und einer Anschlagplatte, damit eine Druckkraft auf die Platte durch eine verstärkte Druckwirkung besser erkannt werden kann, weil die Dicke der Folie wegen der Druckkraft verändert wird.

DE 10 2009 011 558 B3 offenbart eine elektrische Betätigungseinrichtung mit einer Trägerplatte, welche mehrere ringförmige Vertiefungen in ihrer Innenseite aufweist. An einem von den Vertiefungen umgebenen Vorsprung der Trägerplatte wird ein Kraftsensor angeordnet, um eine auf die Trägerplatte geübte Druckkraft zu detektieren.

In US 2009 312051 A1 wird ein mobiles Gerät bekannt gegeben, das mit einem oder mehreren druckempfindlichen Eingabebereichen aus piezoelektrischem Material ausgestattet ist.

DE 101 03 563 A1 betrifft eine Eingabevorrichtung, die eine Einrichtung zur Detektion eines durch Finger abgegebenen Signals umfasst, wobei die Einrichtung mit einer Logik zur Verarbeitung des Signals verbunden ist.

US 2007089939 A1 offenbart ein Bedienfeld für einen Aufzug, wobei das Bedienfeld ein druckempfindliches Aktionsfeld aufweist. Das Bedienfeld umfasst weiterhin eine Schichtkonstruktion mit einer Deckplatte, einer Grundplatte und einem Piezoelement, das sich zwischen der Deckplatte und der Grundplatte befindet.

WO 2009153386 A1 betrifft eine Rufgeräteanordnung mit mehreren Tableaus für einen Aufzug. Das Tableau weist mehrere berührungsempfindliche Stellen auf, die als Anruftasten des Aufzugs fungieren.

Der Erfindung liegt die Aufgabe zugrunde, eine Eingabeeinrichtung der vorstehend beschriebenen Art und ein Verfahren vorzuschlagen, bei welchen die Erfassung einer Berührung einer berührungssensitiven Zone eines durch ein plattenförmiges Element gebildeten Steuerpaneels mit einfacheren Mitteln und daher funktionssicherer und kostengünstiger realisiert werden können.

Wie nachstehend beschrieben, wird die Aufgabe durch eine Eingabeeinrichtung sowie durch ein Verfahren zum Generieren eines Steuersignals gelöst. Vorteilhafte Ausgestaltungen und Weiterbildungen gehen aus den abhängigen Ansprüchen hervor.

Die Erfindung wird durch die Merkmale der unabhängigen Ansprüche 1, bzw. 15 definiert.

Unter dem Begriff "plattenförmiges Element" sind hier quaderförmige Bauteile oder quaderförmige Bereiche von Bauteilen zu verstehen, deren Dicke bzw. Höhe im Verhältnis zu deren Länge und Breite relativ gering ist. Die die Dicke eines solchen "plattenförmigen Elements" begrenzenden Flächen bilden dessen Vorderseite und dessen Rückseite und sind im Wesentlichen eben. Ein "plattenförmiges Element" kann beispielsweise aus einem Metallblech, aus einer Kunststoffplatte oder einer Holzstoffplatte bestehen.

Die Merkmale, dass das Steuerpaneel mindestens im Bereich der Eingabezone durchbiegbar angeordnet ist, bzw., dass in einem durchbiegbaren Bereich des Steuerpaneels eine Eingabezone markiert wird, bedeuten hier, dass das das Steuerpaneel bildende plattenförmige Element so angeordnet ist, dass mindestens im Bereich der mindestens einen Eingabezone eine Durchbiegung des Steuerpaneels unbehindert stattfinden kann, wenn eine Druckkraft auf die mindestens eine Eingabezone ausgeübt wird.

Mit der Eingabeeinrichtung und dem Verfahren gemäß der Erfindung wird erreicht, dass mit einfachen, betriebssicheren und kostengünstigen Mitteln erfasst werden kann, ob eine Druckkraft auf eine Eingabezone ausgeübt wird.

Bei einer vorteilhaften Ausführungsform generiert oder verändert der Sensor ein elektrisches Signal, wenn ein Benutzer der Eingabeeinrichtung durch Ausüben einer Druckkraft auf die Eingabezone eine ausreichende Durchbiegung des Steuerpaneels im Bereich der Eingabezone bewirkt. Damit wird mit einfachsten Mitteln erreicht, dass ein Fingerdruck auf eine Eingabezone - bzw. auf eine von mehreren möglichen Eingabezonen - eines undurchbrochenen Steuerpaneels in ein elektrisches Signal des dieser Eingabezone zugeordneten Sensors umgesetzt werden kann. Das Resultat ist eine Eingabeeinrichtung, die verschmutzungsunempfindlich, vandalenresistent und somit sehr betriebssicher ist.

Bei einer weiteren möglichen Ausführungsform ist der Sensor derart auf dem der Eingabezone gegenüber liegenden Bereich der Rückseite des Steuerpaneels angebracht, dass die durch die Druckkraft bewirkte Durchbiegung des Steuerpaneels im Bereich der Eingabezone eine Verformung des Sensors zur Folge hat. Eine solche Verformung kann beispielsweise eine Biegungs- oder Dehnungsverformung eines Sensors sein. Damit wird eine besonders einfache und kostengünstige Lösung für eine Erfassung der Durchbiegung des Steuerpaneels im Bereich der Eingabezone und damit für die Erfassung einer auf die Eingabezone ausgeübten Druckkraft erreicht.

Bei einer weiteren möglichen Ausführungsform des Erfindungsgegenstands umfasst die Eingabeeinrichtung eine Signalgeberschaltung, welche in Abhängigkeit von dem vom Sensor generierten oder veränderten elektrischen Signal ein Steuersignal mit gewünschten Eigenschaften generiert. Damit wird erreicht, dass mit einfachen und kostengünstigen Mitteln das durch einen Fingerdruck auf eine Eingabezone bewirkte elektrische Signal des Sensors in ein Steuersignal der Eingabeeinrichtung mit den erforderlichen Eigenschaften umgesetzt werden kann.

Bei einer weiteren möglichen Ausführungsform ist mindestens ein Sensor auf einen einer Eingabezone gegenüber liegenden Bereich der Rückseite des Steuerpaneels geklebt. Damit wird erreicht, dass mit handelsüblichen und kostengünstigen Mitteln und wenig Herstellungsaufwand eine betriebssichere Erfassung einer Druckkraft realisiert werden kann, welche Druckkraft beispielsweise in Form eines Fingerdrucks auf ein als durchbrechungsfreie Platte ausgeführtes Steuerpaneel ausgeübt wird. Eine alternative Lösung besteht darin, dass der Sensor nicht auf den der Eingabezone gegenüber liegenden Bereich der Rückseite des Steuerpaneels geklebt wird, sondern nur elastisch an diesen Bereich angepresst wird.

Bei einer weiteren möglichen Ausführungsform umfasst mindestens eine Signalgeberschaltungen der Eingabeeinrichtung einen Tiefpassfilter, der Störschwingungen des elektrischen Signals des Sensors reduziert. Solche Störschwingungen können durch einen Fingerdruck beim Ausüben einer Druckkraft auf eine Eingabezone des Steuerpaneels durch einen Benutzer der Eingabeeinrichtung oder durch andere Störungsquellen, beispielsweise durch Erschütterungen des Steuerpaneels, verursacht werden. Mit der Anwendung eines Tiefpassfilters werden solche Störungsquellen weitgehend eliminiert und dadurch die Betriebssicherheit der Eingabeeinrichtung erhöht.

Bei einer weiteren möglichen Ausführungsform umfasst mindestens eine Signalgeberschaltung der Eingabeeinrichtung mindestens eine Verstärkerschaltung, die das elektrische Signal des Sensors verstärkt. Dies hat insbesondere den Vorteil, dass das aus dem elektrischen Signal gewonnene und von der Eingabeeinrichtung über eine relativ grosse Distanz zu übermittelnde Steuersignal ausreichend stark und gegen Störsignale unempfindlich ist.

Bei einer weiteren möglichen Ausführungsform umfasst mindestens eine Signalgeberschaltung der Eingabeeinrichtung eine Verstärkerschaltung mit einstellbar variierbarer Verstärkung. Dadurch kann beispielsweise erreicht werden, dass ein Signal eines Sensors besonders stark verstärkt wird, wenn der Sensor zu einem Steuerpaneel gehört, das durch ein plattenförmiges Element mit erhöhtem Durchbiegewiderstand gebildet ist.

Eine weitere mögliche Ausführungsform zeichnet sich dadurch aus, dass mindestens eine der Signalgeberschaltungen der Eingabeeinrichtung eine Schwellwertschaltung umfasst, die das von der Dynamik der Ausübung der Druckkraft abhängige, verstärkte elektrische Signal des Sensors in ein Rechtecksignal umsetzt. Damit wird eine eindeutig interpretierbare und sichere Übertragung des erzeugten Steuersignals gewährleistet.

Bei einer weiteren möglichen Ausführungsform ist die Eingabeeinrichtung derart ausgestaltet, dass
- das Steuerpaneel mehrere Eingabezonen und mehrere Sensoren aufweist,
- auf den den Eingabezonen gegenüber liegenden Bereichen der Rückseite des Steuerpaneels jeweils ein Sensor angebracht ist,
- die Eingabeeinrichtung mehrere Signalgeberschaltungen umfasst, von denen jeweils eine mit einem der Sensoren verbunden und damit einer der Eingabezonen zugeordnet ist,
- einer der Sensoren ein elektrisches Signal generiert oder verändert und die mit diesem einen Sensor verbundene Signalgeberschaltung ein Steuersignal mit gewünschten Eigenschaften generiert, wenn auf die Eingabezone, der dieser Sensor zugeordnet ist, eine Druckkraft ausgeübt wird.

Damit wird erreicht, dass auf einem durchbrechungsfreien, verschmutzungs- und vandalensicheren Steuerpaneel mehrere Eingabezonen angeordnet sein können und für jede der Eingabezonen betriebssicher und kostengünstig ein zugeordnetes Steuersignal generiert werden kann.

Eine weitere mögliche Ausführungsform zeichnet sich dadurch aus, dass das Steuerpaneel der Eingabeeinrichtung
- ein plattenförmiges Element eines Schachttürrahmens aus Stahlblech oder
- Teil eines plattenförmigen Frontpaneels eines Schachttürflügels aus Stahlblech oder
- Teil einer plattenförmigen, stockwerksseitigen Wandverkleidung oder
- Teil einer plattenförmigen Aufzugskabinenwand oder Teil einer plattenförmigen Kabinenwandverkleidung einer Aufzugskabine
der Aufzugsanlage ist. Eine solche Ausführungsform der Eingabeeinrichtung hat die wesentlichen Vorteile, dass sie mit besonders geringem Aufwand platzierbar und daher besonders kostengünstig realisierbar ist.

Bei einer weiteren möglichen Ausführungsform umfasst die Eingabeeinrichtung einen Sender, der die generierten Steuersignale drahtlos an einen Empfänger einer Aufzugssteuerung übermittelt. Dies hat insbesondere den Vorteil, dass keine Leitungen zwischen der Aufzugssteuerung und einer Vielzahl von auf den Stockwerken der Aufzugsanlage angeordneten Eingabeeinrichtungen, beispielsweise Aufzugs-RufEinrichtungen, verlegt werden müssen. Die daraus resultierenden Vereinfachungen bewirken insbesondere bei Aufzugsanlagen mit vielen Stockwerken wesentliche Kosteneinsparungen.

Im Folgenden sind Ausführungsbeispiele der Erfindung anhand der beigefügten Zeichnungen erläutert.
- Fig. 1A: zeigt einen Schnitt durch ein Steuerpaneel gemäss einer ersten Ausführungsform einer Eingabeeinrichtung,
- Fig. 1B: zeigt einen Schnitt durch ein Steuerpaneel gemäss einer zweiten Ausführungsform einer Eingabeeinrichtung,
- Fig. 2A: zeigt ein Blockdiagramm mit Hauptkomponenten und Funktionen einer Eingabeeinrichtung mit einer ersten Ausführungsform eines Biegungssensors,
- Fig. 2B: zeigt das Blockdiagramm gemäss Fig. 2A einer Eingabeeinrichtung mit einer zweiten Ausführungsform eines Biegungssensors, und
- Fig. 3: zeigt eine Sicht auf eine Schachttüre und eine dahinter positionierte Aufzugskabine einer Aufzugsanlage mit Anordnungsmöglichkeiten von Eingabeeinrichtungen bzw. von den markierten Eingabezonen solcher Eingabeeinrichtungen.

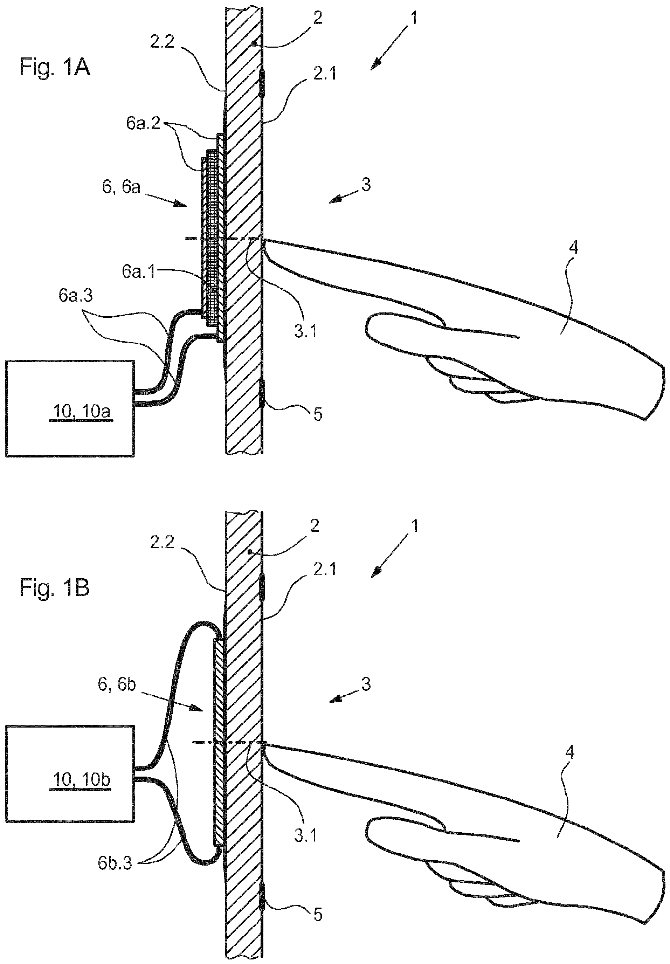

Fig. 1A und Fig. 1B zeigen jeweils einen Schnitt durch eine Eingabeeinrichtung 1 zum Generieren mindestens eines Steuersignals. Die Eingabeeinrichtung 1 umfasst ein Steuerpaneel 2, das durch ein plattenförmiges Element, beispielsweise eine Metallblechplatte, eine Kunststoffplatte oder eine Holzstoffplatte, gebildet ist. Auf der Vorderseite 2.1 des Steuerpaneels 2 ist mindestens eine Eingabezone 3 vorgesehen, auf welche ein Benutzer 4 eine Druckkraft ausüben kann, um zu bewirken, dass die Eingabeeinrichtung ein dieser Eingabezone zugeordnetes Steuersignal generiert. Die Position der Eingabezone 3 ist auf dem Steuerpaneel 2 mittels einer Markierung 5 markiert, welche in diesem Ausführungsbeispiel als Kreisring um das Zentrum 3.1 der Eingabezone 3 dargestellt ist. Die Markierung 5 kann jedoch auch anders, beispielsweise als Kreisfläche oder als Fadenkreuz gestaltet sein, um das Zentrum der Eingabezone zu kennzeichnen. Eine solche Markierung kann beispielsweise durch Gravieren, Ätzen, Lackieren, oder auch durch Aufkleben einer mit der Markierung bedruckten Folie auf die Vorderseite 2.1 des Steuerpaneels 2 aufgebracht sein.

Des Weiteren umfasst die Eingabeeinrichtung 1 mindestens einen Sensor 6, der auf einem der Eingabezone gegenüber liegenden Bereich der Rückseite des Steuerpaneels 2 derart angebracht ist, dass er eine durch das Ausüben einer Druckkraft bewirkte Durchbiegung des Steuerpaneels im Bereich der Eingabezone 3 erfassen kann. Vorzugsweise ist der Sensor 6 zu diesem Zweck mittels eines geeigneten Klebstoffs auf die Rückseite des Steuerpaneels 2 geklebt.

Bei der in Fig. 1A dargestellten ersten Ausführungsform der Eingabeeinrichtung 1 ist der Sensor 6 in Form eines Piezo-Biegungssensors 6a vorhanden, der die durch das Ausüben einer Druckkraft bewirkte Durchbiegung des Steuerpaneels 2 erfasst. Dieser Piezo-Biegungssensors 6a ist so auf den der Eingabezone 3 gegenüber liegenden Bereich der Rückseite 2.2 des Steuerpaneels aufgeklebt, dass er eine im Wesentlichen gleiche Durchbiegung erfährt, wie das Steuerpaneel 2 im Bereich der Eingabezone 3. Ein solcher Piezo-Biegungssensor umfasst im Wesentlichen eine piezokeramische Platte 6a.1 mit zwei (grossen) Aussenflächen, die jeweils mit metallischen Flächenelektroden 6a.2 verbunden sind. Eine Durchbiegung eines solchen Piezo-Biegungssensors bewirkt in den der einen grossen Aussenfläche näher liegenden Zonen der piezokeramische Platte 6a.1 Druckspannungen und in den der anderen grossen Aussenfläche näher liegenden Zonen Zugspannungen. Beim Erzeugen der Durchbiegung bzw. der Druck- und Zugspannungen resultieren in der piezokeramischen Platte 6a.1 kleinste mechanische Verschiebungen von Ladungsträgern in Querrichtung zu den grossen Aussenflächen, was Ladungsunterschiede zwischen diesen Aussenflächen, bzw. zwischen den mit diesen Aussenflächen leitend verbundenen Flächenelektroden 6a.2 zur Folge hat. Diese Ladungsunterschiede manifestieren sich als von der Stärke der Durchbiegung abhängiges elektrisches Signal des Piezo-Biegungssensors 6a. Dieses elektrische Signal wird über die Anschlussdrähte 6a.3 weitergeleitet und durch eine im Folgenden noch beschriebene, hier mit dem Bezugszeichen 10a bezeichnete Signalgeberschaltung ausgewertet, um ein Steuersignal zu generieren, wenn eine Kraft auf die Eingabezone des Steuerpaneels ausgeübt wird.

Bei der in Fig. 1B dargestellten zweiten Ausführungsform der Eingabeeinrichtung 1 ist der Sensor 6 in Form eines Dehnungsmessstreifen-Biegungssensors 6b vorhanden, der die durch das Ausüben einer Druckkraft bewirkte Durchbiegung des Steuerpaneels 2 im Bereich der Eingabezone 3 erfasst. Dieser Dehnungsmessstreifen-Biegungssensor 6b ist so auf den der Eingabezone 3 gegenüber liegenden Bereich der Rückseite 2.2 des Steuerpaneels aufgeklebt, dass er bei einer Durchbiegung des Steuerpaneels dieselbe Dehnung erfährt, wie der genannte Bereich der Rückseite 2.2. des Steuerpaneels.

Ein solcher Dehnungsmessstreifen-Biegungssensor umfasst üblicherweise eine auf eine Trägerfolie galvanisch aufgetragene, mäanderförmig angeordnete, dünne Leiterbahn, wobei der grösste Teil der Leiterbahnlänge parallel zu einer Längsrichtung des Dehnungsmessstreifens verläuft. Wird ein solcher Dehnungsmessstreifen so auf ein Bauteil geklebt, dass sich die Längsrichtung des Dehnungsmessstreifens parallel zu einer Richtung erstreckt, in welcher die Oberfläche des Bauteils eine Dehnung erfährt, so verändert sich durch die Dehnung der elektrische Widerstand der gesamten Leiterlänge und damit des Dehnungsmessstreifens.

Bei der in Fig. 1B dargestellten zweiten Ausführungsform der Eingabeeinrichtung 1 wird das Steuerpaneel 2 durch Ausüben einer Druckkraft im Bereich der Eingabezone 3 durchgebogen, so dass die Rückseite des Steuerpaneels im Bereich dieser Eingabezone eine entsprechende Dehnung erfährt, die auf den auf diesen Bereich geklebten Dehnungsmessstreifen-Biegungssensor übertragen wird. Infolge dieser Dehnung des Dehnungsmessstreifens des Dehnungsmessstreifen-Biegungssensors 6b verändert sich der elektrische Widerstand des Dehnungsmessstreifen-Biegungssensors 6b. Ist der Dehnungsmessstreifen-Biegungssensors 6b über seine Anschlussdrähte 6b.3 an eine im Folgenden beschriebene, hier mit dem Bezugszeichen 10b bezeichnete Signalgeberschaltung angeschlossen, so bewirkt das Ausüben einer Kraft auf die Eingabezone 3 des Steuerpaneels 2 eine von der Stärke der Kraft abhängige Veränderung eines Spannungsabfalls im Stromkreis des Dehnungsmessstreifen-Biegungssensors 6b. Dieser Spannungsabfall wird als elektrisches Signal des Dehnungsmessstreifen-Biegungssensors 6b von der Signalgeberschaltung 10b ausgewertet, um ein Steuersignal zu generieren, wenn eine Kraft auf die Eingabezone des Steuerpaneels ausgeübt wird.

Eine Eingabeeinrichtung kann ein Steuerpaneel 2 umfassen, das mehrere nebeneinander angeordnete Eingabezonen 3 und mehrere, jeweils einer der Eingabezonen zugeordnete Sensoren 6 umfasst. Jeder Eingabezone und damit jedem der Sensoren 6 ist dabei eine Signalgeberschaltung 10 zugeordnet, wobei jede der Signalgeberschaltungen ein Steuersignal mit gewünschten Eigenschaften generiert, wenn der ihr zugeordnete Sensor ein elektrisches Signal generiert oder verändert, weil auf die Eingabezone, der dieser Sensor zugeordnet ist, eine Druckkraft ausgeübt wird.

Angrenzend an die Rückseite des Steuerpaneels 2 im Bereich der mindestens einen Eingabezone 3 ist ein Einbauraum für den mindestens einen am Steuerpaneel fixierten Sensor 6 vorhanden. Ausserdem ist das Steuerpaneel auch nach Anbringung des mindestens einen Sensors mindestens im Bereich der mindestens einen Eingabezone noch ausreichend durchbiegbar. Da die Dicke eines vorgesehenen Sensors in der Grössenordnung von einem Millimeter liegt und die Durchbiegung des Steuerpaneels im Bereich der Eingabezone im üblichen Anwendungsfall höchstens einige Zehntelmillimeter beträgt, ist angrenzend an die Rückseite des Steuerpaneels ein Hohlraum von etwa zwei Millimetern Dicke ausreichend.

Als Alternative zum Aufkleben des mindestens einen Sensors 6 auf den der Eingabezone 3 gegenüber liegenden Bereich der Rückseite 2.2 des Steuerpaneels 2 kann der Sensor 6 auch mittels einer Halterung elastisch an die genannte Rückseite des Steuerpaneels angepresst werden. Eine Durchbiegung des Steuerpaneels 2 im Bereich der Eingabezone 3 kann auch auf diese Weise auf den Piezo-Biegungssensors 6a bzw. auf den Dehnungsmessstreifen-Biegungssensors 6b übertragen werden.

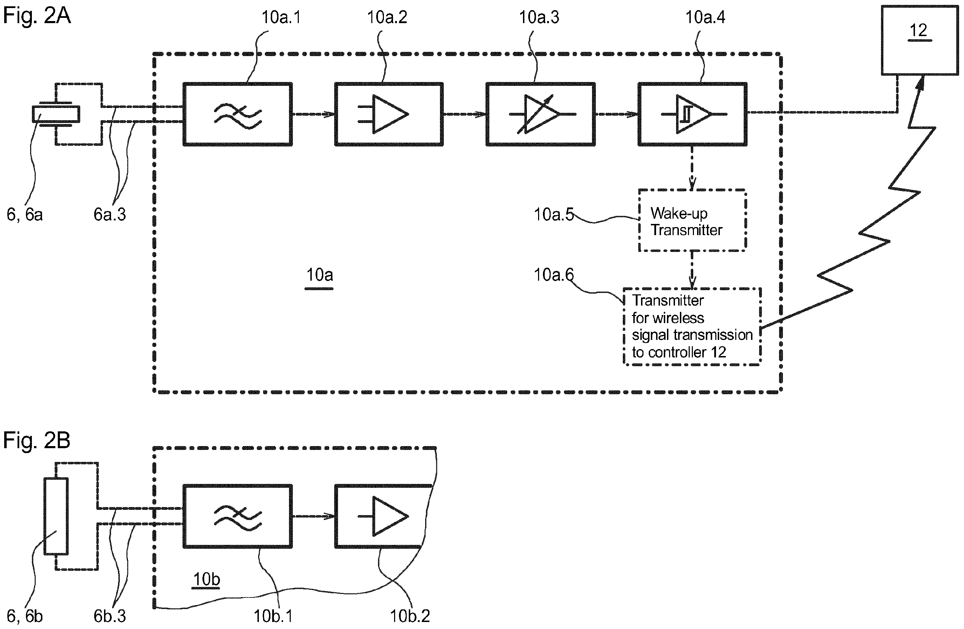

Fig. 2A und Fig. 2B zeigen Blockschaltpläne von Signalgeberschaltungen 10, die dazu vorgesehen sind, in Abhängigkeit von dem von einem Sensor 6 generierten oder veränderten elektrischen Signal, d. h. in Abhängigkeit vom Vorhandensein und von der Stärke einer auf eine zugeordnete Eingabezone des Steuerpaneels ausgeübten Kraft, ein Steuersignal mit gewünschten Eigenschaften zu generieren. Die Signalgeberschaltungen gemäss Fig. 2A und Fig. 2B unterscheiden sich dadurch, dass sie mit unterschiedlichen Ausführungsformen des vorstehend im Zusammenhang mit den Fig. 1A und 1B beschriebenen Sensors 6 zusammenwirken, welcher Sensor 6 dazu dient, eine Durchbiegung einer zugeordneten Eingabezone zu detektieren. Wegen der unterschiedlichen Sensoren weisen die beiden Signalgeberschaltungen teilweise unterschiedliche Komponenten auf.

Fig. 2A zeigt eine Signalgeberschaltung 10a, an die ein Sensor 6 in Form eines Piezo-Biegesensors 6a angeschlossen ist. Wie vorstehend beschrieben, generiert der Piezo-Biegesensor 6a Ladungsunterschiede zwischen zwei Flächenelektroden, wenn er eine Durchbiegung erfährt. Die Ladungsunterschiede manifestieren sich als von der Stärke der Durchbiegung abhängiges elektrisches Signal, das über Anschlussdrähte 6a.3 an den Eingang der Signalgeberschaltung 10a weitergeleitet wird. Mittels eines Tiefpassfilters 10a.1 der Signalgeberschaltung 10a wird das Signal des Piezo-Biegesensors 6a geglättet, und an eine Verstärkerschaltung 10a.2 in Form eines Ladungsverstärkers weitergeleitet. Durch das Glätten werden Störschwingungen des elektrischen Signals des Sensors reduziert, welche Störschwingungen beispielsweise durch Erschütterungen des Steuerpaneels oder durch die Art des Fingerdrucks verursacht werden.

Der genannte Ladungsverstärker 10a.2 wandelt die dem geglätteten Signal des Sensors entsprechende elektrische Ladung in eine zu dieser etwa proportionale Spannung um. Diese Spannung wird anschliessend durch eine Verstärkerschaltung 10a.3 in Form eines Spannungsverstärkers mit einstellbar variierbarer Verstärkung verstärkt und einem Schwellwertschalter 10a.4 in Form eines Schmitt-Triggers zugeführt. Die einstellbar variierbare Verstärkung ermöglicht es, die Signalgeberschaltung an unterschiedliche Anwendungsfälle anzupassen, beispielsweise an unterschiedliche Steuerpaneele, die bei gleicher Druckkraft auf die Eingabezone unterschiedlich starke Durchbiegungen erfahren. Die Aufgabe des Schwellwertschalters 10a.4 besteht darin, die sich kontinuierlich entsprechend der ausgeübten Druckkraft verändernden, verstärkten Signale des Sensors in Rechtecksignale umzusetzen, d. h., jeweils bei definierten Spannungsniveaus der verstärkten Signale des Sensors schlagartig ein Ausgangssignal zum Steuern einer Einrichtung zwischen zwei Spannungsniveaus umzuschalten.

Das Ausgangssignal des Schwellwertschalters 10a.4 der Signalgeberschaltung 10a kann als Steuersignal über eine Signalleitung an eine Steuerung 12 einer Einrichtung übermittelt werden. Nach einer der möglichen Ausführungsformen der Eingabeeinrichtung kann das genannte Ausgangssignal des Schwellwertschalters 10a jedoch auch auf eine Sendeeinrichtung 10a.6 übertragen werden, die das genannte Ausgangssignal in ein drahtlos übertragbares Steuersignal umsetzt und dieses an einen entsprechenden Signalempfänger der Steuerung 12 einer Einrichtung übermittelt. Damit die Sendeeinrichtung 10a.6 nur dann aktiviert wird und dabei Energie verbraucht, wenn ein Steuersignal zu übertragen ist, kann eine Aufweckschaltung 10a.5 vorhanden sein, die die Sendeeinrichtung aktiviert, wenn der Schwellwertschalter 10a ein Ausgangssignal generiert.

Fig. 2B zeigt einen Ausschnitt aus einer Signalgeberschaltung 10b, an die ein Sensor 6 in Form eines Dehnungsmessstreifen-Biegungssensor 6b angeschlossen ist. Wie vorstehend im Zusammenhang mit Fig. 1B beschrieben, bewirkt die Ausübung einer Druckkraft auf die Eingabezone eine Dehnung des Dehnungsmessstreifen-Biegungssensors, wodurch sich dessen elektrischer Widerstand und damit das vom Dehnungsmessstreifen-Biegungssensor 6b über einen der Anschlussdrähte 6b.3 an den Eingang der Signalgeberschaltung 10b geführte Spannungssignal in etwa proportional zur genannten Druckkraft verändern. Mittels eines Tiefpassfilters 10b.1 der Signalgeberschaltung 10b wird das Signal des Dehnungsmessstreifen-Biegungssensors 6b geglättet, und an eine Verstärkerschaltung 10b.2 in Form eines Spannungsverstärkers weitergeleitet. Die übrigen Komponenten und Funktionen der Signalgeberschaltung 10b entsprechen den vorstehend beschriebenen Komponenten 10a.3 bis 10a.6 der Signalgeberschaltung 10a und deren Funktionen.

Die Eingabeeinrichtung ist Teil einer Aufzugsanlage wobei sie einem Aufzugsbenutzer ermöglicht, ein Steuersignal zur Beeinflussung der Steuerung 12 der Aufzugsanlage zu generieren, beispielsweise indem der Aufzugsbenutzer durch Fingerdruck auf eine Eingabezone eines durch ein Bauteil der Aufzugsanlage gebildeten Steuerpaneels die Aufzugskabine auf ein bestimmtes Stockwerk ruft.

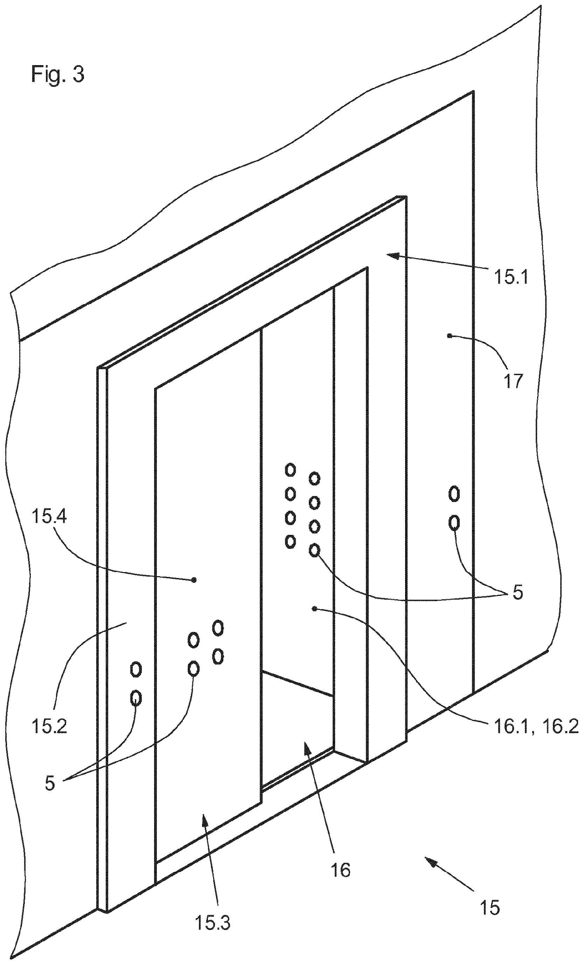

Fig. 3 zeigt eine Schachttüre 15 und eine dahinter positionierte Aufzugskabine 16 einer Aufzugsanlage mit Anordnungsmöglichkeiten von Eingabeeinrichtungen. Dabei sind von den verschiedener Eingabeeinrichtungen jeweils nur die die Eingabezonen anzeigenden Markierungen 5 sichtbar, da die die Eingabezonen bzw. die Markierungen 5 enthaltenden Steuerpaneele durch plattenförmige Elemente bzw. plattenförmige Bereiche von Bauteilen der Aufzugsanlage gebildet sind. Aus Fig. 3 sind folgende zur Bildung eines Steuerpaneels einer erfindungsgemässen Eingabeeinrichtung geeignete, plattenförmige Elemente bzw. plattenförmige Bereiche enthaltende Bauteile erkennbar:
- ein Türpfosten 15.2 des Schachttürrahmens 15.1 aus Metallblech
- eine plattenförmige Schachtwandverkleidung 17 im Bereich der Schachttüre 15 aus

Metallblech, Kunststoffplatten, Holzstoffplatten, etc.
- ein Frontpaneel 15.4 eines Schachttürflügels 15.3 aus Metallblech
- eine Kabinenwand 16.1 oder eine Kabinenwandverkleidung 16.2 der Aufzugskabine 16, wobei die Kabinenwand bzw. die Kabinenwandverkleidung aus Metallblech, Kunststoffplatten, Holzstoffplatten oder Platten aus einem anderen Material bestehen können.

## Patentansprüche

1. Eingabeeinrichtung (1) einer Aufzuganlage zum Generieren eines Steuersignals zur Steuerung der Aufzugsanlage, umfassend
- ein Steuerpaneel (2), das durch ein plattenförmiges Element der Aufzugsanlage gebildet ist und eine Vorderseite (2.1) und eine Rückseite (2.2) aufweist,
- eine Eingabezone (3) auf der Vorderseite (2.1) des Steuerpaneels (2), wobei die Position der Eingabezone (3) mittels einer Markierung (5) auf der Vorderseite (2.1) des Steuerpaneels (2) markiert ist, und wobei das Steuerpaneel (2) mindestens im Bereich der Eingabezone (3) durchbiegbar angeordnet ist, und
- einen Piezo-Biegungssensor oder als Dehnungsmessstreifen-Biegungssensor (6), der auf einem der Eingabezone (3) gegenüber liegenden Bereich der Rückseite (2.2) des Steuerpaneels (2) derart angebracht ist, dass er eine im Bereich der Eingabezone (3) auftretende Durchbiegung des Steuerpaneels (2) erfasst.

2. Eingabeeinrichtung (1) nach Anspruch 1, **dadurch gekennzeichnet, dass** der Sensor (6) ein elektrisches Signal generiert oder verändert, wenn ein Benutzer der Eingabeeinrichtung (1) durch Ausüben einer Druckkraft auf die Eingabezone (3) eine ausreichende Durchbiegung des Steuerpaneels (2) im Bereich der Eingabezone (3) bewirkt.

3. Eingabeeinrichtung (1) nach Anspruch 2, **dadurch gekennzeichnet, dass** der Sensor (6) derart auf der Rückseite (2.2) des Steuerpaneels (2) angebracht ist, dass die durch das Ausüben einer Druckkraft bewirkte Durchbiegung des Steuerpaneels (2) im Bereich der Eingabezone (3) eine Verformung des Sensors (6) zur Folge hat.

4. Eingabeeinrichtung (1) nach einem der Ansprüche 1 bis 3, **dadurch gekennzeichnet, dass** die Eingabeeinrichtung (1) eine Signalgeberschaltung (10a; 10b) umfasst, welche in Abhängigkeit von dem vom Sensor (6) generierten oder veränderten elektrischen Signal ein Steuersignal generiert.

5. Eingabeeinrichtung (1) nach einem der Ansprüche 1 bis 4, **dadurch gekennzeichnet, dass** der Sensor (6) auf einen einer Eingabezone (3) gegenüber liegenden Bereich der Rückseite (2.2) des Steuerpaneels (2) geklebt ist.

6. Eingabeeinrichtung (1) nach einem der Ansprüche 3 bis 5, **dadurch gekennzeichnet, dass** die Signalgeberschaltung (10a; 10b) der Eingabeeinrichtung (1) einen Tiefpassfilter (10a.1) umfasst, der Störschwingungen des elektrischen Signals des Sensors (6) reduziert.

7. Eingabeeinrichtung (1) nach einem der Ansprüche 3 bis 6, **dadurch gekennzeichnet, dass** die Signalgeberschaltung (10a; 10b) der Eingabeeinrichtung (1) eine Verstärkerschaltung (10a.2, 10a.3; 10b.2) umfasst, die das elektrische Signal des Sensors (6) verstärkt.

8. Eingabeeinrichtung (1) nach Anspruch 7, **dadurch gekennzeichnet, dass** die Verstärkerschaltung (10a.3) eine einstellbare variierbare Verstärkung hat.

9. Eingabeeinrichtung (1) nach Anspruch 7 oder 8, **dadurch gekennzeichnet, dass** die Signalgeberschaltung (10a; 10b) der Eingabeeinrichtung (1) eine Schwellwertschaltung (10a.4) umfasst, die das verstärkte elektrische Signal des Sensors (6) in ein Rechtecksignal umsetzt.

10. Eingabeeinrichtung (1) nach einem der Ansprüche 1 bis 9, **dadurch gekennzeichnet, dass**
- das Steuerpaneel mehrere Eingabezonen (3) und mehrere Sensoren (6) aufweist,
- auf den den Eingabezonen (3) gegenüber liegenden Bereichen der Rückseite (2.2) des Steuerpaneels (2) jeweils ein Sensor (6) angebracht ist,
- die Eingabeeinrichtung (1) mehrere Signalgeberschaltungen (10a; 10b) umfasst, von denen jeweils eine mit einem der Sensoren (6) verbunden und damit einer der Eingabezonen (3) zugeordnet ist,
- einer der Sensoren (6) ein elektrisches Signal generiert oder verändert und die mit diesem einen Sensor (6) verbundene Signalgeberschaltung (10a; 10b) ein Steuersignal mit gewünschten Eigenschaften generiert, wenn auf die Eingabezone (3), der dieser eine Sensor (6) zugeordnet ist, eine Druckkraft ausgeübt wird.

11. Aufzuganlage mit einer Eingabeeinrichtung (1) nach einem der Ansprüche 1 bis 10.

12. Aufzugsanlage nach Anspruch 11, **dadurch gekennzeichnet, dass** das Steuerpaneel (2) der Eingabeeinrichtung (1)
- ein plattenförmiges Element eines Schachttürrahmens (15.1) aus Stahlblech oder
- Teil eines plattenförmigen Frontpaneels (15.4) eines Schachttürflügels (15.3) aus Stahlblech oder
- Teil einer plattenförmigen, stockwerksseitigen Wandverkleidung (17) oder
- Teil einer plattenförmigen Aufzugskabinenwand (16.1) oder Teil einer plattenförmigen Kabinenwandverkleidung (16.2) einer Aufzugskabine 16 der Aufzugsanlage ist.

13. Aufzugsanlage nach einem der Ansprüche 11 bis 12, **dadurch gekennzeichnet, dass** die Eingabeeinrichtung (1) einen Sender (10a.6) umfasst, der die generierten Steuersignale drahtlos an einen Signalempfänger einer Aufzugssteuerung übermittelt.

14. Verfahren zum Generieren eines Steuersignals mit einer Eingabeeinrichtung (1) einer Aufzugsanlage nach einem der Ansprüche 1 bis 10, wobei das Verfahren folgende Schritte umfasst:
- auf die Eingabezone (3) des Steuerpaneels (2) wird eine Druckkraft ausgeübt, wodurch eine Durchbiegung des Steuerpaneels (2) im Bereich der Eingabezone (3) und daraus resultierend eine Durchbiegung des Biegungssensors (6) bewirkt werden,
- als Folge der Durchbiegung des Biegungssensors (6) wird durch den Biegungssensor (6) ein elektrisches Signal eine generiert oder verändert, und
das elektrische Signal des Biegungssensors (6) wird durch die Signalgeberschaltung (10a; 10b) in ein Steuersignal mit den gewünschten Eigenschaften umgesetzt.

## Claims

1. Input device (1) of an elevator installation for generating a control signal for controlling the elevator installation, comprising
- a control panel (2) which is formed by a planar element of the elevator installation and has a front face (2.1) and a rear face (2.2),
- an input zone (3) on the front face (2.1) of the control panel (2), wherein the position of the input zone (3) is marked by means of a marking (5) on the front face (2.1) of the control panel (2), and wherein the control panel (2) is arranged so as to be deflectable, at least in the region of the input zone (3), and
- a piezo bending sensor or as a strain gauge bending sensor (6) which is attached to a region of the rear face (2.2) of the control panel (2) that is opposite the input zone (3) in such a way that said sensor detects a deflection in the region of the input zone (3) of the control panel (2).

2. Input device (1) according to claim 1, **characterized in that** the sensor (6) generates or changes an electrical signal when a user of the input device (1) causes a sufficient deflection of the control panel (2) in the region of the input zone (3) by exerting pressure on the input zone (3).

3. Input device (1) according to claim 2, **characterized in that** the sensor (6) is attached to the rear face (2.2) of the control panel (2) in such a way that the deflection of the control panel (2) in the region of the input zone (3) caused by the exertion of pressure results in a deformation of the sensor (6).

4. Input device (1) according to any of claims 1 to 3, **characterized in that** the input device (1) comprises a signal transmitter circuit (10a; 10b) which generates a control signal depending on the electrical signal generated or changed by the sensor (6).

5. Input device (1) according to any of claims 1 to 4, **characterized in that** the sensor (6) is bonded to a region of the rear face (2.2) of the control panel (2) that is opposite an input zone (3).

6. Input device (1) according to any of claims 3 to 5, **characterized in that** the signal transmitter circuit (10a; 10b) of the input device (1) comprises a low-pass filter (10a.1) which reduces parasitic oscillations in the electrical signal from the sensor (6).

7. Input device (1) according to any of claims 3 to 6, **characterized in that** the signal transmitter circuit (10a; 10b) of the input device (1) comprises an amplifier circuit (10a.2, 10a.3; 10b.2), which amplifies the electrical signal from the sensor (6).

8. Input device (1) according to claim 7, **characterized in that** the amplifier circuit (10a.3) has an adjustable, variable amplification.

9. Input device (1) according to either claim 7 or claim 8, **characterized in that** the signal transmitter circuit (10a; 10b) of the input device (1) comprises a threshold circuit (10a.4) which converts the amplified electrical signal from the sensor (6) into a square wave signal.

10. Input device (1) according to any of claims 1 to 9, **characterized in that**
- the control panel has a plurality of input zones (3) and a plurality of sensors (6),
- a sensor (6) is attached to each of the regions of the rear face (2.2) of the control panel (2) that are opposite the input zones (3),
- the input device (1) comprises a plurality of signal transmitter circuits (10a; 10b), each of which is connected to one of the sensors (6) and is thus assigned to one of the input zones (3),
- one of the sensors (6) generates or changes an electrical signal, and the signal transmitter circuit (10a; 10b) connected to said sensor (6) generates a control signal having desired properties when pressure is exerted on the input zone (3) to which said sensor (6) is assigned.

11. Elevator installation comprising an input device (1) according to any of claims 1 to 10.

12. Elevator installation according to claim 11, **characterized in that** the control panel (2) of the input device (1) is
- a planar element of a shaft door frame (15.1) made of sheet steel or
- part of a planar front panel (15.4) of a shaft door leaf (15.3) made of sheet steel or
- part of a planar, floor-side wall cladding (17) or
- part of a planar elevator car wall (16.1) or part of a planar car wall cladding (16.2) of an elevator car 16 of the elevator installation.

13. Elevator installation according to any of claims 11 to 12, **characterized in that** the input device (1) comprises a transmitter (10a.6) which wirelessly transmits the generated control signals to a signal receiver of an elevator controller.

14. Method for generating a control signal by means of an input device (1) of an elevator installation according to any of claims 1 to 10, wherein the method comprises the following steps:
- pressure is exerted on the input zone (3) of the control panel (2), causing a deflection of the control panel (2) in the region of the input zone (3) and, as a result, a deflection of the bending sensor (6),
- as a result of the deflection of the bending sensor (6), an electrical signal is generated or changed by the bending sensor (6), and the electrical signal from the bending sensor (6) is converted by the signal transmitter circuit (10a; 10b) into a control signal having the desired properties.

## Revendications

1. Dispositif de saisie (1) d'une installation d'ascenseur destiné à générer un signal de commande destiné à commander l'installation d'ascenseur, comprenant
- un panneau de commande (2) qui est formé par un élément en forme de plaque de l'installation d'ascenseur et qui présente une face avant (2.1) et une face arrière (2.2),
- une zone de saisie (3) sur la face avant (2.1) du panneau de commande (2), la position de la zone de saisie (3) étant marquée au moyen d'un marquage (5) sur la face avant (2.1) du panneau de commande (2), et le panneau de commande (2) étant conçu pour être flexible au moins dans la région de la zone de saisie (3), et
- un capteur de flexion piézoélectrique ou un capteur de flexion à jauge extensomé-trique (6), lequel est monté sur une région de la face arrière (2.2) du panneau de commande (2) opposée à la zone de saisie (3), de telle sorte qu'il détecte une flexion du panneau de commande (2) se produisant dans la région de la zone de saisie (3).

2. Dispositif de saisie (1) selon la revendication 1, **caractérisé en ce que** le capteur (6) génère ou modifie un signal électrique lorsqu'un utilisateur du dispositif de saisie (1) provoque une flexion suffisante du panneau de commande (2) dans la région de la zone de saisie (3) par application d'une pression sur la zone de saisie (3).

3. Dispositif de saisie (1) selon la revendication 2, **caractérisé en ce que** le capteur (6) est monté sur la face arrière (2.2) du panneau de commande (2) de telle sorte que la flexion du panneau de commande (2) dans la région de la zone de saisie (3), qui est provoquée par l'application d'une pression, entraîne une déformation du capteur (6).

4. Dispositif de saisie (1) selon l'une des revendications 1 à 3, **caractérisé en ce que** le dispositif de saisie (1) comprend un circuit émetteur de signaux (10a; 10b), lequel génère un signal de commande en fonction du signal électrique généré ou modifié par le capteur (6).

5. Dispositif de saisie (1) selon l'une des revendications 1 à 4, **caractérisé en ce que** le capteur (6) est collé sur une région de la face arrière (2.2) du panneau de commande (2) opposée à une zone de saisie (3).

6. Dispositif de saisie (1) selon l'une des revendications 3 à 5, **caractérisé en ce que** le circuit émetteur de signaux (10a; 10b) du dispositif de saisie (1) comprend un filtre passe-bas (10a.1) qui réduit les oscillations parasites du signal électrique du capteur (6).

7. Dispositif de saisie (1) selon l'une des revendications 3 à 6, **caractérisé en ce que** le circuit émetteur de signaux (10a; 10b) du dispositif de saisie (1) comprend un circuit amplificateur (10a.2, 10a.3; 10b.2) qui amplifie le signal électrique du capteur (6).

8. Dispositif de saisie (1) selon la revendication 7, **caractérisé en ce que** le circuit amplificateur (10a.3) possède une amplification réglable et variable.

9. Dispositif de saisie (1) selon la revendication 7 ou 8, **caractérisé en ce que** le circuit émetteur de signaux (10a; 10b) du dispositif de saisie (1) comprend un circuit de valeur de seuil (10a.4) qui convertit le signal électrique amplifié du capteur (6) en un signal rectangulaire.

10. Dispositif de saisie (1) selon l'une des revendications 1 à 9, **caractérisé en ce que**
- le panneau de commande présente plusieurs zones de saisie (3) et plusieurs capteurs (6),
- un capteur (6) est respectivement monté sur les régions de la face arrière (2.2) du panneau de commande (2) opposées aux zones de saisie (3),
- le dispositif de saisie (1) comprend une pluralité de circuits émetteurs de signaux (10a; 10b) dont l'un est respectivement connecté à l'un des capteurs (6) et est ainsi associé à l'une des zones de saisie (3),
- l'un des capteurs (6) génère ou modifie un signal électrique et le circuit émetteur de signaux (10a; 10b) connecté audit capteur (6) génère un signal de commande doté des propriétés souhaitées lors de l'application d'une pression sur la zone de saisie (3) à laquelle est associé ledit capteur (6).

11. Installation d'ascenseur comportant un dispositif de saisie (1) selon l'une des revendications 1 à 10.

12. Installation d'ascenseur selon la revendication 11, **caractérisée en ce que** le panneau de commande (2) du dispositif de saisie (1)
- est un élément en forme de plaque d'un cadre de porte de cage (15.1) en tôle d'acier, ou
- fait partie d'un panneau avant en forme de plaque (15.4) d'un vantail de porte de cage (15.3) en tôle d'acier, ou
- fait partie d'un revêtement de paroi en forme de plaque (17) côté sol, ou
- fait partie d'une paroi de cabine d'ascenseur en forme de plaque (16.1) ou fait partie d'un revêtement de paroi de cabine en forme de plaque (16.2) d'une cabine d'ascenseur (16) de l'installation d'ascenseur.

13. Installation d'ascenseur selon l'une des revendications 11 à 12, **caractérisée en ce que** le dispositif de saisie (1) comprend un émetteur (10a.6) qui transmet sans fil les signaux de commande générés à un récepteur de signaux d'une commande d'ascenseur.

14. Procédé de génération d'un signal de commande à l'aide d'un dispositif de saisie (1) d'une installation d'ascenseur selon l'une des revendications 1 à 10, le procédé comprenant les étapes suivantes :
- l'application d'une pression sur la zone de saisie (3) du panneau de commande (2), ce qui provoque une flexion du panneau de commande (2) dans la région de la zone de saisie (3) et, par conséquent, une flexion du capteur de flexion (6),
- à la suite de la flexion du capteur de flexion (6), la génération ou la modification, par le capteur de flexion (6), d'un signal électrique, et la conversion, par le circuit émetteur de signaux (10a; 10b), du signal électrique du capteur de flexion (6) en un signal de commande doté des propriétés souhaitées.
